# EUROPEAN PATENT APPLICATION

(11) **EP 4 280 272 A1**
(43) Date of publication of application: **22.11.2023**
(21) Application number: 22766728.4
(22) Date of filing: 10.02.2022
(51) Int. Cl.: H01L 23/40, H01L 23/473, H05K 7/20, H01S 5/02326

(54) **LASER DEVICE**

(30) Priority: 09.03.2021 JP 2021037273
(71) Applicant: Hamamatsu Photonics K.K., Hamamatsu-shi, Shizuoka 435-8558 (JP)
(72) Inventor: HATANO, Yuma, Hamamatsu-shi, Shizuoka 435-8558 (JP); SEKINE, Takashi, Hamamatsu-shi, Shizuoka 435-8558 (JP); MURAMATSU, Yuki, Hamamatsu-shi, Shizuoka 435-8558 (JP); TAMAOKI, Yoshinori, Hamamatsu-shi, Shizuoka 435-8558 (JP)
(74) Representative: Grünecker Patent- und Rechtsanwälte PartG mbB
(86) International application number: PCT/JP2022/005411
(87) International publication number: WO 2022/190763

(57) **Abstract**

A laser device includes a support, a first heat sink, a plurality of laser light sources attached to the support, and a plurality of electrodes bridged between the plurality of laser light sources and the first heat sink. Each of the plurality of laser light sources is movable with respect to the support. Each of the plurality of electrodes is electrically connected to one of the plurality of laser light sources at a first connection portion, and is thermally connected to the first heat sink at a second connection portion. In each of the plurality of electrodes, an extension part between the first connection portion and the second connection portion has flexibility, and a length of the extension part is larger than a linear distance between the first connection portion and the second connection portion.

## Description

### Technical Field

The present disclosure relates to a laser device.

### Background Art

Patent Document 1 describes a laser array module that includes a cooling manifold, a plurality of laser array units attached to the cooling manifold, and a plurality of lead-out electrodes electrically connected to the plurality of laser array units. In the laser array module described in Patent Document 1, the plurality of lead-out electrodes are disposed in a plurality of grooves formed in the cooling manifold. Thereby, efficient cooling is realized for the plurality of laser array units and the plurality of lead-out electrodes.

### Citation List

### Patent Literature

[Patent Literature 1] Japanese Unexamined Patent Publication No. 2005-268650

### Summary of Invention

### Technical Problem

However, in the laser array module described in Patent Literature 1, since adjusting positions of the laser array units is not particularly considered, in order to reliably obtain a high-quality optical output, it is necessary to improve assembly accuracy of components to reduce machine differences.

An objective of the present disclosure is to provide a laser device in which a high-quality optical output can be reliably obtained with a simple configuration.

### Solution to Problem

A laser device of one aspect of the present disclosure includes a support, a first heat sink, a plurality of laser light sources attached to the support, and a plurality of electrodes bridged between the plurality of laser light sources and the first heat sink, in which each of the plurality of laser light sources is movable with respect to the support, each of the plurality of electrodes is electrically connected to each of the plurality of laser light sources at a first connection portion, and is thermally connected to the first heat sink at a second connection portion, an extension part between the first connection portion and the second connection portion has flexibility in each of the plurality of electrodes, and a length of the extension part is larger than a linear distance between the first connection portion and the second connection portion.

In the laser device, each of the laser light sources is movable with respect to the support, the extension part between the first connection portion and the second connection portion has flexibility in each of the electrodes, and a length of the extension part is larger than a linear distance between the first connection portion and the second connection portion. Thereby, a position of the laser light source can be adjusted with the electrode electrically connected to the laser light source. Further, since the electrode is thermally connected to the first heat sink, deterioration of the electrode due to heat generation can be suppressed. Therefore, according to the laser device, a high-quality optical output can be reliably obtained with a simple configuration.

In the laser device of one aspect of the present disclosure, each of the plurality of electrodes may have a sheet shape. According to this, manufacturing can be facilitated compared to a case in which, for example, the electrode is configured by a plurality of wires. Also, deterioration of the electrode due to heat generation can be suppressed while maintaining flexibility of the extension part compared to a case in which, for example, the electrode is configured by a plurality of wires. This is because, in order to suppress deterioration of the electrode due to heat generation in the electrode configured by the plurality of wires, each of the wires needs to be made thicker or the number of wires needs to be increased, and in such a case, flexibility of the electrode is impaired. Further, when the electrode has a sheet shape, there is an advantage that physical disconnection does not easily occur even if the electrode is bent or twisted compared to a case in which, for example, the electrode is configured by a plurality of wires.

In the laser device of one aspect of the present disclosure, the extension part may be floated in an air between the first connection portion and the second connection portion. According to this, a position of the laser light source can be more easily adjusted with the electrode electrically connected to the laser light source.

In the laser device of one aspect of the present disclosure, the first heat sink may be provided with a first refrigerant flow path. According to this, the electrodes can be more efficiently cooled.

In the laser device of one aspect of the present disclosure, each of the plurality of laser light sources may include a second heat sink, and a semiconductor laser array thermally connected to the second heat sink. According to this, the semiconductor laser array can be efficiently cooled in each of the laser light sources. Since an amount of heat due to the semiconductor laser array is larger than an amount of heat due to a single-element semiconductor laser, a configuration in which the semiconductor laser array is cooled using the second heat sink is effective.

In the laser device of one aspect of the present disclosure, the second heat sink may be provided with a second refrigerant flow path. According to this, the semiconductor laser array can be more efficiently cooled in each of the laser light sources.

The laser device of one aspect of the present disclosure may further include a plurality of hoses having flexibility, in which each of the plurality of hoses may be connected to the second refrigerant flow path. According to this, a position of the laser light source can be more easily adjusted with the electrode electrically connected to the laser light source.

The laser device of one aspect of the present disclosure may further include a conductive member, in which the plurality of laser light sources may have a first laser light source and a second laser light source, the plurality of electrodes may have a first electrode electrically connected to a cathode of the first laser light source and a second electrode electrically connected to an anode of the second laser light source, and the first electrode and the second electrode may be electrically connected by the conductive member. According to this, wiring can be simplified, and furthermore, a size of the laser device can be reduced.

In the laser device of one aspect of the present disclosure, the conductive member may be thermally connected to the first heat sink. According to this, deterioration of the conductive member due to heat generation can be suppressed.

In the laser device of one aspect of the present disclosure, a cross-sectional area of the conductive member may be larger than a cross-sectional area of each of the first electrode and the second electrode. According to this, electrical resistance of the first electrode, the second electrode, and the conductive member as a whole can be lowered, and heat generation of them as a whole can be suppressed.

The laser device of one aspect of the present disclosure may further include an optical element, in which the plurality of laser light sources may have a third laser light source configured to emit laser light toward the optical element in a first direction, and a fourth laser light source configured to emit laser light toward the optical element in a second direction intersecting the first direction, and the optical element may reflect the laser light emitted from the third laser light source and may transmit the laser light emitted from the fourth laser light source. According to this, the laser light emitted from the third laser light source and the laser light emitted from the fourth laser light source can be combined in a desired state by adjusting a positional relationship between the third laser light source and the fourth laser light source.

In the laser device of one aspect of the present disclosure, the optical element may be a mirror. According to this, it is possible to reliably and easily realize a configuration in which the laser light emitted from the third laser light source is reflected and the laser light emitted from the fourth laser light source is transmitted.

In the laser device of one aspect of the present disclosure, each of the third laser light source and the fourth laser light source may include a plurality of semiconductor laser bars stacked in a third direction intersecting both the first direction and the second direction, and each of the third laser light source and the fourth laser light source may be movable in the third direction with respect to the support. According to this, gaps between laser light emitted from the plurality of semiconductor laser bars of the third laser light source can be filled with laser light emitted from the plurality of semiconductor laser bars of the fourth laser light source by adjusting a positional relationship between the third laser light source and the fourth laser light source.

In the laser device of one aspect of the present disclosure, the optical element may include a plurality of light reflecting portions configured to reflect the laser light emitted from the third laser light source, and a plurality of light transmitting portions configured to transmit the laser light emitted from the fourth laser light source, and the plurality of light reflecting portions and the plurality of light transmitting portions may be alternately aligned in the third direction. According to this, the laser light emitted from the third laser light source can be reliably made incident on the plurality of light reflecting portions by adjusting a position of the third laser light source. Also, the laser light emitted from the fourth laser light source can be reliably made incident on the plurality of light transmitting portions by adjusting a position of the fourth laser light source. As a result of the above, a high-quality optical output can be obtained while reducing loss of light.

The laser device of one aspect of the present disclosure may further include a prism optical system configured to collect laser light emitted from each of the plurality of laser light sources into a predetermined region. According to this, a high-quality optical output can be obtained in the predetermined region.

### Advantageous Effects of Invention

According to the present disclosure, it is possible to provide a laser device in which a high-quality optical output can be reliably obtained with a simple configuration.

### Brief Description of Drawings

FIG. 1 is a side view of a laser device of one embodiment.
FIG. 2 is a plan view of the laser device illustrated in FIG. 1.
FIG. 3 is a perspective view of a laser light source unit illustrated in FIG. 1.
FIG. 4 is a cross-sectional view along line IV-IV illustrated in FIG. 3.
FIG. 5 is a cross-sectional view along line V-V illustrated in FIG. 4.
FIG. 6 is a rear view of a portion of the laser light source unit illustrated in FIG. 5.
FIG. 7 is a perspective view of a piping unit included in the laser light source unit illustrated in FIG. 3.
FIG. 8 is a perspective view of a piping unit included in the laser light source unit illustrated in FIG. 3.

### Description of Embodiments

Hereinafter, embodiments of the present disclosure will be described in detail with reference to the drawings. In each of the drawings, the same or corresponding portions are denoted by the same reference signs, and duplicate descriptions thereof will be omitted.

### [Configuration of laser device]

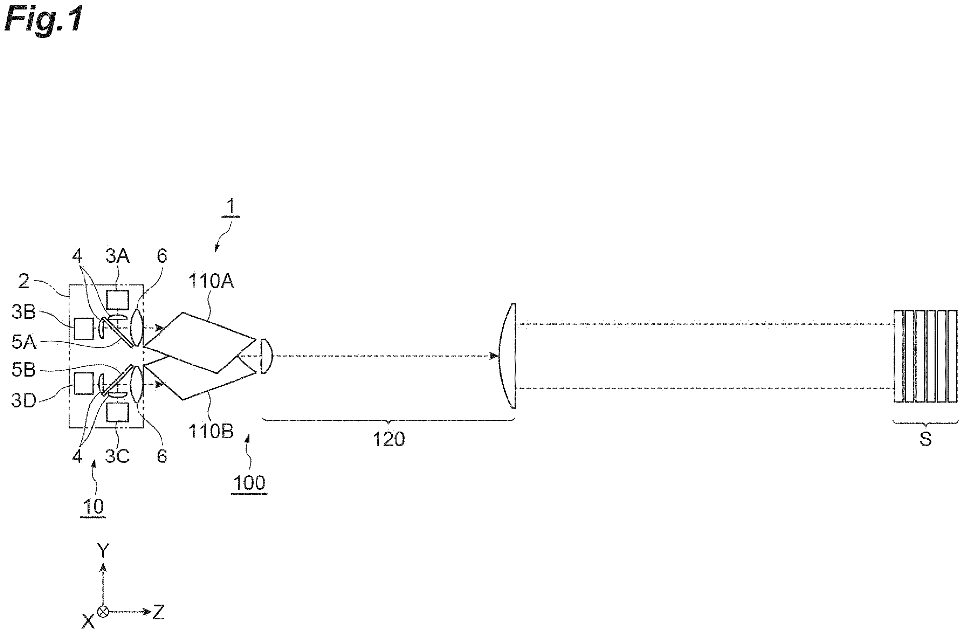

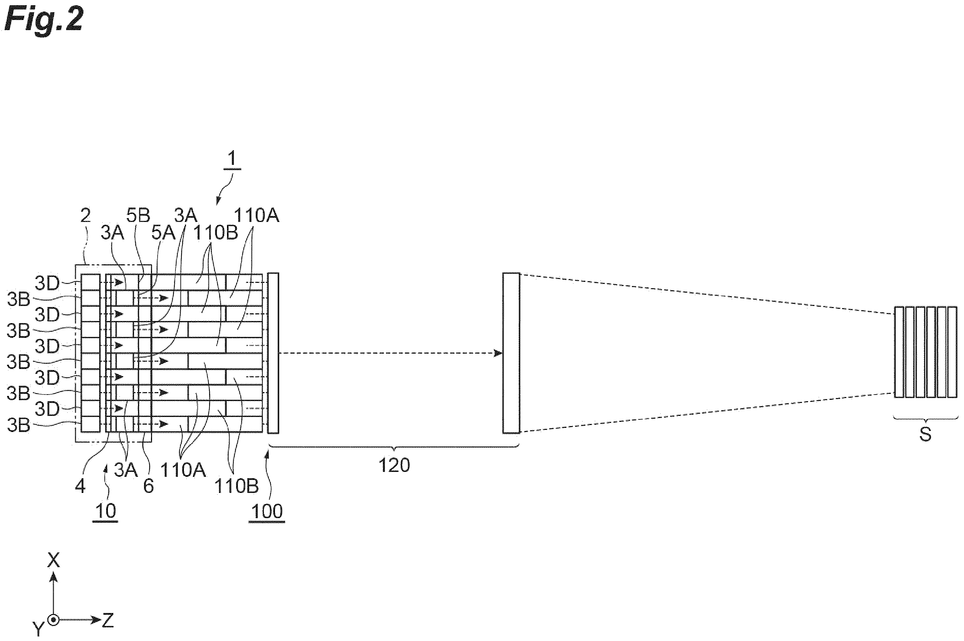

As illustrated in FIGS 1 and 2, a laser device 1 includes a laser light source unit 10 and a prism optical system 100. The laser light source unit 10 includes a support 2, a plurality of laser light sources 3A, 3B, 3C, and 3D, a plurality of slow axis collimator lenses 4, a plurality of mirrors (optical elements) 5A and 5B, and a plurality of slow axis collimator lenses 6. The plurality of laser light sources 3A, 3B, 3C, and 3D, the plurality of slow axis collimator lenses 4, the plurality of mirrors 5A and 5B, and the plurality of slow axis collimator lenses 6 are supported by the support 2.

The plurality of mirrors 5A are aligned in an X-axis direction at intervals. The plurality of mirrors 5B are disposed on one side in a Y-axis direction that is perpendicular to the X-axis direction with respect to the plurality of mirrors 5A, and are aligned in the X-axis direction at intervals. The mirrors 5A and the mirrors 5B are alternately aligned in the X-axis direction when viewed from the Y-axis direction. Hereinafter, one side in the Y-axis direction will be referred to as a "lower side," and a side opposite thereto will be referred to as an "upper side". Also, one side in a Z-axis direction perpendicular to both the X-axis direction and the Y-axis direction is referred to as a "rear side," and a side opposite thereto is referred to as a "front side".

Each of the laser light sources 3Ais disposed on a side above each of the mirrors 5A. The laser light source 3A emits laser light (illustrated by a broken line in FIGS. 1 and 2) toward the mirror 5A (that is, downward) in the Y-axis direction. Each of the laser light sources 3B is disposed on a side behind each of the mirrors 5A. The laser light source 3B emits laser light toward the mirror 5A (that is, forward) in the Z-axis direction. The mirror 5A reflects the laser light emitted from the laser light source 3A forward, and transmits the laser light emitted from the laser light source 3B forward.

Each of the laser light sources 3C is disposed on a side below each of the mirrors 5B. The laser light source 3C emits laser light toward the mirror 5B (that is, upward) in the Y-axis direction. Each of the laser light sources 3D is disposed on a side behind each of the mirrors 5B. The laser light source 3D emits laser light toward the mirror 5B (that is, forward) in the Z-axis direction. The mirror 5B reflects the laser light emitted from the laser light source 3C forward, and transmits the laser light emitted from the laser light source 3D forward.

Although details will be described later, the laser light sources 3A, 3B, 3C, and 3D each have the same structure and include a plurality of light emitting regions (not illustrated) disposed in a matrix. The laser light source 3A is disposed such that the laser light is emitted downward from a light emitting region with the X-axis direction as a fast axis direction and the Z-axis direction as a slow axis direction. The laser light source 3B is disposed such that laser light is emitted forward from a light emitting region with the X-axis direction as a fast axis direction and the Y-axis direction as a slow axis direction. The laser light source 3C is disposed such that laser light is emitted upward from a light emitting region with the X-axis direction as a fast axis direction and the Z-axis direction as a slow axis direction. The laser light source 3D is disposed such that laser light is emitted forward from a light emitting region with the X-axis direction as a fast axis direction and the Y-axis direction as a slow axis direction. Further, in the present embodiment, a set of the plurality of laser light emitted from the plurality of light emitting regions in each of the laser light sources 3A, 3B, 3C, and 3D is simply referred to as "laser light".

The plurality of slow axis collimator lenses 4 are disposed such that one slow axis collimator lens 4 is positioned between the laser light source 3A and the mirror 5A, between the laser light source 3B and the mirror 5A, between the laser light source 3C and the mirror 5B, and between the laser light source 3D and the mirror 5B. The slow axis collimator lenses 4 collimate the laser light emitted from the laser light sources 3A, 3B, 3C, and 3D in the slow axis direction, respectively. The plurality of slow axis collimator lenses 6 are disposed such that one slow axis collimator lens 6 is positioned in front of the mirror 5A and in front of the mirror 5B. The slow axis collimator lenses 6 collimate the laser light emitted from the mirror 5A and 5B in the slow axis direction, respectively.

The prism optical system 100 collects the laser light emitted from the respective slow axis collimator lenses 6 (that is, the laser light emitted from the respective laser light sources 3A, 3B, 3C, and 3D) into a solid-state laser medium (predetermined region) S. The prism optical system 100 shapes the laser light emitted from the respective slow axis collimator lens 6 so that an intensity distribution of the laser light becomes uniform in a laser light irradiation region of a solid-state laser medium S. As an example, the solid-state laser medium S generates emission light on a resonant optical path of a laser resonator by being irradiated with laser light emitted from the laser device 1 as excitation light.

The prism optical system 100 includes a plurality of prisms 110A and 110B, and an image-forming optical system 120. The plurality of prisms 110A are disposed so that an incident surface of one prism 110A is positioned in front of the slow axis collimator lens 6 disposed in front of the mirror 5A. The plurality of prisms 110B are disposed so that an incident surface of one prism 110B is positioned in front of the slow axis collimator lens 6 disposed in front of the mirror 5B. The prisms 110A and 110B emit laser light with positions of optical axes of the laser light being the same in the Y-axis direction. The image-forming optical system 120 is formed of, for example, a plurality of cylindrical lenses, and is disposed in front of the plurality of prisms 110A and 110B. The image-forming optical system 120 causes the laser light emitted from the prisms 110A and 110B to be converged on the solid-state laser medium S.

### [Configuration of laser light source unit]

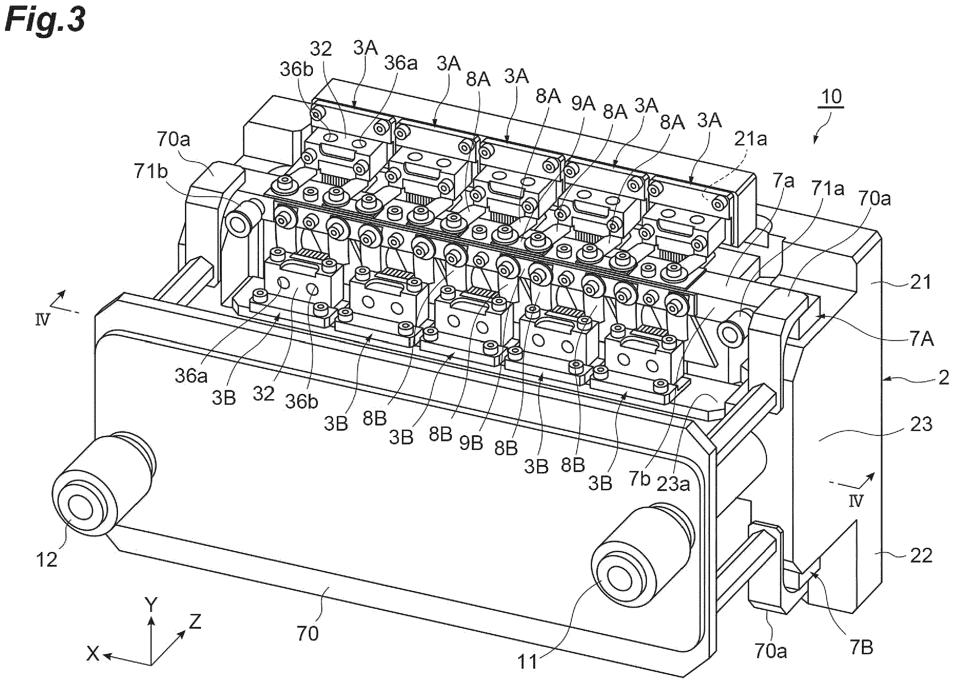

As illustrated in FIGS. 3, 4 and 5, in the laser light source unit 10, the support 2 includes an upper portion 21, a lower portion 22, and a rear portion 23. The upper portion 21 extends in the X-axis direction and is positioned on an upper side with respect to the rear portion 23. The lower portion 22 extends in the X-axis direction and is positioned on a lower side with respect to the rear portion 23. The rear portion 23 extends in the X-axis direction and is positioned on a rear side with respect to the upper portion 21 and the lower portion 22. The plurality of laser light sources 3A and 3B, the plurality of mirrors 5A, and the plurality of slow axis collimator lenses 4 and 6 corresponding thereto (hereinafter referred to as "a configuration related to the plurality of laser light sources 3A and 3B") are attached to the upper portion 21 in the positional relationship described above. The plurality of laser light sources 3C and 3D, the plurality of mirrors 5B, and the plurality of slow axis collimator lenses 4 and 6 corresponding thereto (hereinafter referred to as "a configurations related to the plurality of laser light sources 3C and 3D") are attached to the lower portion 22 in the positional relationship described above.

The upper portion 21 has a support surface 21a facing rearward. The lower portion 22 has a support surface 22a facing rearward. The rear portion 23 has a support surface 23a facing upward and a support surface 23b facing downward. The support surfaces 21a, 22a, 23a, and 23b extend in the X-axis direction.

The plurality of laser light sources 3A are attached to the support surface 21a of the upper portion 21. The plurality of laser light sources 3A are aligned in the X-axis direction at intervals. The plurality of laser light sources 3B are attached to the support surface 23a of the rear portion 23. The plurality of laser light sources 3B are aligned in the X-axis direction at intervals. The plurality of laser light sources 3C are attached to the support surface 22a of the lower portion 22. The plurality of laser light sources 3C are aligned in the X-axis direction at intervals. The plurality of laser light sources 3D are attached to the support surface 23b of the rear portion 23. The plurality of laser light sources 3D are aligned in the X-axis direction at intervals.

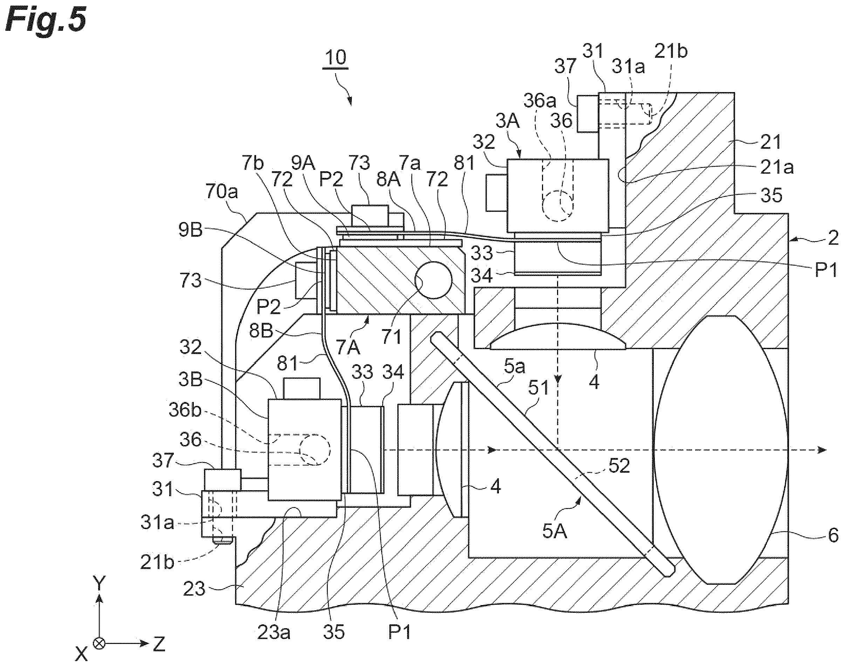

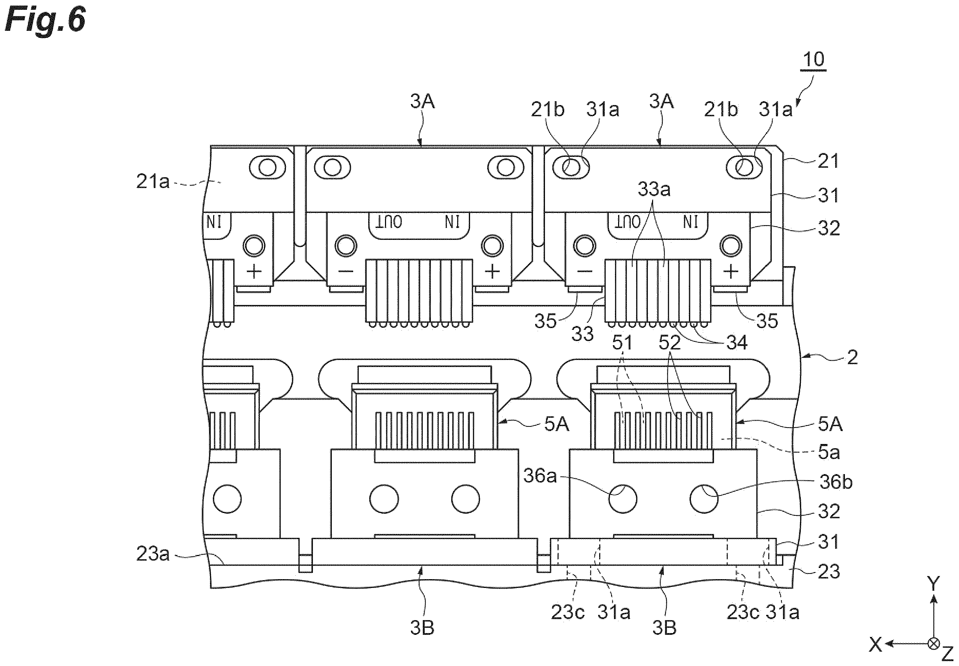

Here, a configuration on the plurality of laser light sources 3A and 3B will be described with reference to FIGS. 5 and 6. As illustrated in FIGS. 5 and 6, the laser light source 3A and 3B each include a base 31, a heat sink (second heat sink) 32, a semiconductor laser array 33, a plurality of fast axis collimator lenses 34, and a pair of terminals 35. The heat sink 32 is fixed to the base 31. The semiconductor laser array 33 is fixed to the heat sink 32 and thermally connected to the heat sink 32. The plurality of fast axis collimator lenses 34 are fixed to emission end surfaces of the semiconductor laser array 33 (details will be described later). The pair of terminals 35 are terminals for applying a voltage to the semiconductor laser array 33, and are provided on both sides of the semiconductor laser array 33 in the X-axis direction.

The heat sink 32 of each of the laser light sources 3A and 3B is provided with a refrigerant flow path (second refrigerant flow path) 36. A refrigerant (for example, water or the like) is supplied to the refrigerant flow path 36 through a pipe (not illustrated). In the heat sink 32, the refrigerant is introduced from an introduction port 36a of the refrigerant flow path 36 and discharged from an outlet port 36b of the refrigerant flow path 36 (see FIG. 3).

A plurality of pairs of screw holes 21b are formed in the support surface 21a of the upper portion 21 to correspond to the plurality of laser light sources 3A. A pair of elongated holes 31a having a longitudinal direction in the X direction is formed in the base 31 of each of the laser light sources 3A to correspond to the pair of screw holes 21b. For the laser light source 3A, a pair of bolts 37 are screwed into the pair of screw holes 21b through the pair of elongated holes 31a, and thereby the laser light source 3A is attached to the support surface 21a so that the laser light (illustrated by a broken line in FIG. 5) is emitted downward from the semiconductor laser array 33. With such an attachment structure, the laser light source 3A is movable with respect to the support 2 in the X-axis direction. Further, in FIG. 6, illustration of the plurality of bolts 37 is omitted.

A plurality of pairs of screw holes 23c are formed in the support surface 23a of the rear portion 23 to correspond to the plurality of laser light sources 3B. The pair of elongated holes 31a having a longitudinal direction in the X direction is formed in the base 31 of each of the laser light sources 3B to correspond to the pair of screw holes 23c. For the laser light source 3B, the pair of bolts 37 are screwed into the pair of screw holes 23c through the pair of elongated holes 31a, and thereby the laser light source 3B is attached to the support surface 23a so that laser light is emitted forward from the semiconductor laser array 33. With such an attachment structure, the laser light source 3B is movable with respect to the support 2 in the X-axis direction.

The laser light source (third laser light source) 3A emits the laser light toward the mirror 5A in the Y-axis direction (first direction). The semiconductor laser array 33 of the laser light source 3A includes a plurality of semiconductor laser bars 33a stacked in the X-axis direction. The semiconductor laser bars 33a of the laser light source 3A each have a plurality of light emitting regions (not illustrated) aligned in the Z-axis direction. The laser light is emitted from each of the light emitting regions of the laser light source 3A with the X-axis direction as the fast axis direction and the Z-axis direction as the slow axis direction. In the laser light source 3A, the fast axis collimator lenses 34 are fixed to the emission end surfaces of the semiconductor laser bars 33a, and collimate the laser light emitted from the light emitting regions in the fast axis direction.

The laser light source (fourth laser light source) 3B emits laser light toward the mirror 5A in the Z-axis direction (second direction). The semiconductor laser array 33 of the laser light source 3B includes the plurality of semiconductor laser bars 33a stacked in the X-axis direction. The semiconductor laser bars 33a of the laser light source 3B each have a plurality of light emitting regions (not illustrated) aligned in the Y-axis direction. The laser light is emitted from each of the light emitting regions of the laser light source 3B with the X-axis direction as the fast axis direction and the Y-axis direction as the slow axis direction. In the laser light source 3B, the fast axis collimator lenses 34 are fixed to the emission end surfaces of the semiconductor laser bars 33a, and collimate the laser light emitted from the light emitting regions in the fast axis direction.

The mirror 5A includes a plurality of light reflecting portions 51 and a plurality of light transmitting portions 52. The light reflecting portions 51 each extend in a direction parallel to a line of intersection between a main surface 5a on a front side and an upper side of the mirror 5A and a plane perpendicular to the X-axis direction. Similarly, the plurality of light transmitting portions 52 extend in a direction parallel to the line of intersection. The light reflecting portions 51 and the light transmitting portions 52 are alternately aligned in the X-axis direction (third direction intersecting both the first direction and the second direction). As an example, each of the light reflecting portions 51 is a high reflection coat formed along the main surface 5a, and each of the light transmitting portion 52 is a slit formed in the mirror 5A.

The plurality of light reflecting portions 51 reflect the laser light emitted from the laser light source 3A. More specifically, each of the light reflecting portions 51 reflects the laser light, which has been emitted downward from each semiconductor laser bar 33a of the laser light source 3A, forward. The plurality of light transmitting portions 52 transmit the laser light emitted from the laser light source 3B. More specifically, each of the light transmitting portions 52 transmits the laser light, which has been emitted forward from each semiconductor laser bar 33a of the laser light source 3B, forward.

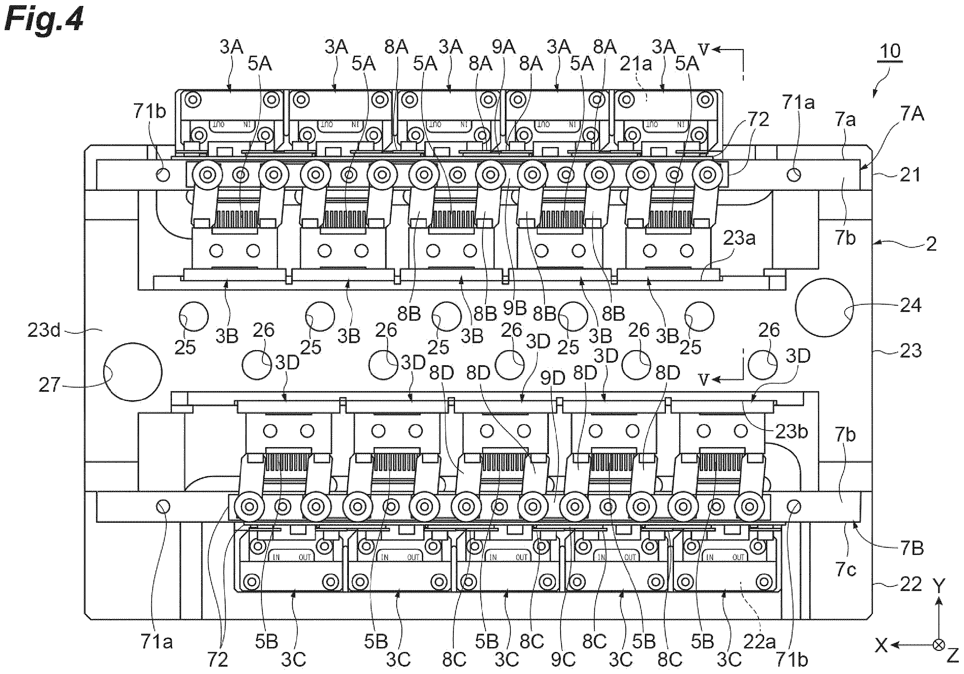

The above is a description of the configuration on the plurality of laser light sources 3A and 3B. Since a configuration on the plurality of laser light sources 3C and 3D is only in a point-symmetric relationship with the configuration on the plurality of laser light sources 3A and 3B with respect to a center point of the support 2 when viewed from the rear side (see FIG. 4), description of the configuration on the plurality of laser light sources 3C and 3D will be omitted.

As illustrated in FIGS. 3, 4, and 5, the laser light source unit 10 further includes a pair of heat sinks (first heat sinks) 7A and 7B, a plurality of electrodes 8A, 8B, 8C, and 8D, and a plurality of conductive members 9A, 9B, 9C, and 9D. The heat sink 7A extends in the X-axis direction on a rear side of the upper portion 21 and on an upper side of the rear portion 23. The heat sink 7B extends in the X-axis direction on a rear side of the lower portion 22 and on a lower side of the rear portion 23. The heat sink 7A is sandwiched between a pair of arms 70a extending from a plate 70 provided to stand on a rear side of the support 2, and the rear portion 23. The heat sink 7B is sandwiched between another pair of arms 70a extending from the plate 70 and the rear portion 23. The heat sinks 7A and 7B are formed of a metal such as, for example, aluminum.

Each of the heat sinks 7A and 7B is provided with a refrigerant flow path (first refrigerant flow path) 71. The refrigerant flow path 71 extends in the X-axis direction inside each of the heat sinks 7A and 7B. A refrigerant (for example, water or the like) is supplied to the refrigerant flow path 71 through a pipe (not illustrated). In each of the heat sinks 7A and 7B, the refrigerant is introduced from an introduction port 71a of the refrigerant flow path 71 and discharged from an outlet port 71b of the refrigerant flow path 71.

The plurality of electrodes 8A are bridged between the plurality of laser light sources 3A and the heat sink 7A. More specifically, each of the electrodes 8A is bridged between the terminal 35 of each of the laser light sources 3A and a surface 7a on an upper side of the heat sink 7A. The electrode 8A is electrically connected to the laser light source 3A at a first connection portion P1, and is thermally connected to the heat sink 7A at a second connection portion P2. Further, the electrode 8A is fixed to the terminal 35 of the laser light source 3A at the first connection portion P1 with a bolt (not illustrated).

The plurality of electrodes 8B are bridged between the plurality of laser light sources 3B and the heat sink 7A. More specifically, each of the electrodes 8B is bridged between the terminal 35 of each of the laser light sources 3B and a surface 7b on a rear side of the heat sink 7A. The electrode 8B is electrically connected to the laser light source 3B at the first connection portion P1, and is thermally connected to the heat sink 7A at the second connection portion P2. Further, the electrode 8B is fixed to the terminal 35 of the laser light source 3B at the first connection portion P1 with a bolt (not illustrated).

The plurality of electrodes 8C are bridged between the plurality of laser light sources 3C and the heat sink 7B. More specifically, each of the electrodes 8C is bridged between the terminal 35 of each of the laser light sources 3C and a surface 7c on a lower side of the heat sink 7B. The electrode 8C is electrically connected to the laser light source 3C at the first connection portion P1, and is thermally connected to the heat sink 7B at the second connection portion P2. Further, the electrode 8C is fixed to the terminal 35 of the laser light source 3C at the first connection portion P1 with a bolt (not illustrated).

The plurality of electrodes 8D are bridged between the plurality of laser light sources 3D and the heat sink 7B. More specifically, each of the electrodes 8D is bridged between the terminal 35 of each of the laser light sources 3D and a surface 7b on a rear side of the heat sink 7B. The electrode 8D is electrically connected to the laser light source 3D at the first connection portion P1, and is thermally connected to the heat sink 7B at the second connection portion P2. Further, the electrode 8D is fixed to the terminal 35 of the laser light source 3D at the first connection portion P1 with a bolt (not illustrated).

The electrodes 8A, 8B, 8C, and 8D each have a sheet shape. The electrodes 8A, 8B, 8C, and 8D each have, for example, a thickness of about 100 µm, a width of about 8 mm, and a length of about 40 mm. The electrodes 8A, 8B, 8C, and 8D are formed of, for example, copper. In each of the electrodes 8A, 8B, 8C, and 8D, an extension part 81 between the first connection portion P1 and the second connection portion P2 has flexibility. The extension parts 81 of the electrodes 8A, 8B, 8C, and 8D are each floated in the air between the first connection portion P1 and the second connection portion P2. In each of the electrodes 8A, 8B, 8C, and 8D, a length of the extension part 81 is longer than a linear distance between the first connection portion P1 and the second connection portion P2. The electrode 8A, 8B, 8C, and 8D each have an allowance between the first connection portion P1 and the second connection portion P2, and are each bent between the first connection portion P1 and the second connection portion P2. The electrodes 8A, 8B, 8C, and 8D are each bridged with an allowance (freely installed) between the first connection portion P1 and the second connection portion P2. In the present embodiment, the electrodes 8A, 8B, 8C, and 8D are each a member that has flexibility as a whole including the extension part 81, and can be bent and twisted. Further, for each of the electrodes 8A, 8B, 8C, and 8D, since the laser light sources 3A, 3B, 3C, and 3D are each movable with respect to the support 2, a position of the first connection portion P1 changes, and a linear distance between the first connection portion P1 and the second connection portion P2 changes. A length of the extension part 81 need only be longer than a minimum value (a minimum value within a range in which each of the laser light sources 3A, 3B, 3C, and 3D is movable with respect to the support 2) of the linear distance between the first connection portion P1 and the second connection portion P2. It is more preferable that the length of the extension part 81 be equal to or larger than a maximum value (a maximum value within a range in which each of the laser light sources 3A, 3B, 3C, and 3D is movable with respect to the support 2) of the linear distance between the first connection portion P1 and the second connection portion P2.

The conductive members 9A are each disposed on the surface 7a of the heat sink 7A. The conductive member 9A is thermally connected to the heat sink 7A. Focusing on a pair of adjacent laser light sources 3A, an electrode (first electrode) 8A electrically connected to a cathode (that is, the terminal 35 on a cathode side) of one laser light source (first laser light source) 3A and an electrode (second electrode) 8A electrically connected to an anode (that is, the terminal 35 on an anode side) of the other laser light source (second laser light source) 3A are electrically connected by the conductive member 9A. Thereby, in the plurality of laser light sources 3A, the plurality of semiconductor laser arrays 33 are electrically connected in series.

The conductive members 9B are each disposed on the surface 7b of the heat sink 7A. The conductive member 9B is thermally connected to the heat sink 7A. Focusing on a pair of adjacent laser light sources 3B, an electrode (first electrode) 8B electrically connected to a cathode (that is, the terminal 35 on a cathode side) of one laser light source (first laser light source) 3B and an electrode (second electrode) 8B electrically connected to an anode (that is, the terminal 35 on an anode side) of the other laser light source (second laser light source) 3B are electrically connected by the conductive member 9B. Thereby, in the plurality of laser light sources 3B, the plurality of semiconductor laser arrays 33 are electrically connected in series.

The conductive members 9C are each disposed on the surface 7c of the heat sink 7B. The conductive member 9C is thermally connected to the heat sink 7B. Focusing on a pair of adjacent laser light sources 3C, an electrode (first electrode) 8C electrically connected to a cathode (that is, the terminal 35 on a cathode side) of one laser light source (first laser light source) 3C and an electrode (second electrode) 8C electrically connected to an anode (that is, the terminal 35 on an anode side) of the other laser light source (second laser light source) 3C are electrically connected by the conductive member 9C. Thereby, in the plurality of laser light sources 3C, the plurality of semiconductor laser arrays 33 are electrically connected in series.

The conductive members 9D are each disposed on the surface 7b of the heat sink 7B. The conductive member 9D is thermally connected to the heat sink 7B. Focusing on a pair of adjacent laser light sources 3D, an electrode (first electrode) 8D electrically connected to a cathode (that is, the terminal 35 on a cathode side) of one laser light source (first laser light source) 3D and an electrode (second electrode) 8D electrically connected to an anode (that is, the terminal 35 on an anode side) of the other laser light source (second laser light source) 3D are electrically connected by the conductive member 9D. Thereby, in the plurality of laser light sources 3D, the plurality of semiconductor laser arrays 33 are electrically connected in series.

The conductive members 9A, 9B, 9C, and 9D each have a plate shape. The conductive members 9A, 9B, 9C, and 9D each have, for example, a thickness of about 1 mm, a width of about 8 mm, and a length of about 22 mm. The conductive members 9A, 9B, 9C, and 9D are formed of, for example, copper. A cross-sectional area of each of the conductive members 9A, 9B, 9C, and 9D (a cross-sectional area perpendicular to a direction in which it extends as a wiring) is larger than a cross-sectional area of each of the electrodes 8A, 8B, 8C, and 8D (a cross-sectional area perpendicular to a direction in which it extends as a wiring).

Further, the electrode 8A and the conductive member 9A are disposed on the surface 7a of the heat sink 7A via an insulating plate 72 formed of an electrically insulating material (for example, aluminum oxide, aluminum nitride, or the like) to be fixed to the surface 7a of the heat sink 7A by a bolt 73 at the second connection portion P2. The electrode 8B and the conductive member 9B are disposed on the surface 7b of the heat sink 7A via the insulating plate 72 to be fixed to the surface 7b of the heat sink 7A by the bolt 73 at the second connection portion P2. The electrode 8C and the conductive member 9C are disposed on the surface 7c of the heat sink 7B via the insulating plate 72 to be fixed to the surface 7c of the heat sink 7B by the bolt 73 at the second connection portion P2. The electrode 8D and the conductive member 9D are disposed on the surface 7b of the heat sink 7B via the insulating plate 72 to be fixed to the surface 7b of the heat sink 7B by the bolt 73 at the second connection portion P2.

### [Configuration of piping unit]

As illustrated in FIG. 4, a main introduction port 24, a plurality of sub-outlet ports 25, a plurality of sub-introduction ports 26, and a main outlet port 27 are formed on the surface 23d on a rear side of the rear portion 23 of the support 2. The main introduction port 24 is positioned on one side in the X-axis direction. Each of the sub-outlet ports 25 is positioned below each laser light source 3B. Each of the sub-introduction ports 26 is positioned above each laser light source 3D. The main outlet port 27 is positioned on the other side in the X-axis direction. The rear portion 23 is provided with a refrigerant supply flow path (not illustrated) through which a refrigerant (for example, water or the like) to be introduced from the main introduction port 24 and discharged from the plurality of sub-outlet ports 25 flows, and a refrigerant recovery flow path (not illustrated) through which the refrigerant (for example, water or the like) to be introduced from the plurality of sub-introduction ports 26 and discharged from the main outlet port 27 flows. Further, as illustrated in FIG. 3, a main introduction pipe 11 is connected to the main introduction port 24, and a main outlet pipe 12 is connected to the main outlet port 27. The main introduction pipe 11 and the main outlet pipe 12 are supported by the rear portion 23, and pass through holes formed in the plate 70 in a state in which they are spaced apart from the plate 70.

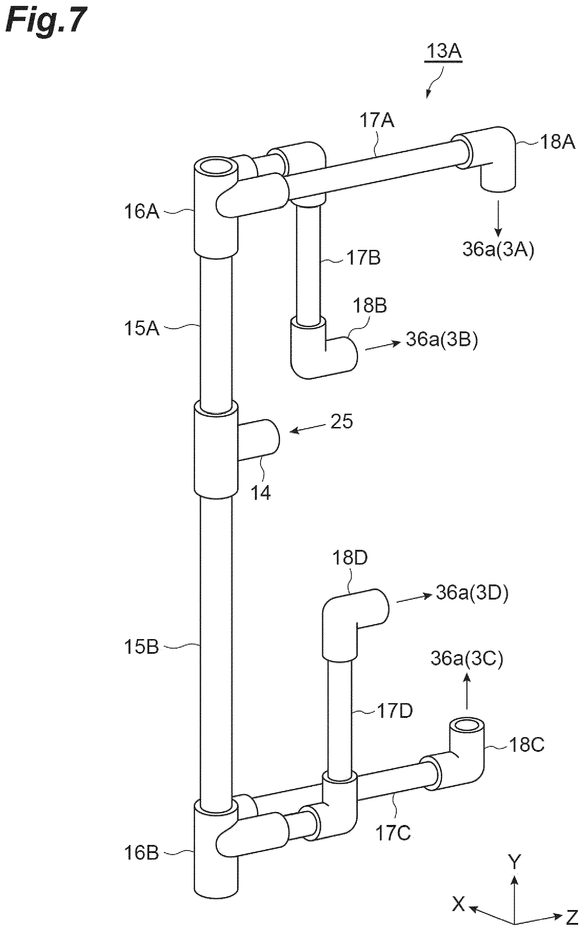

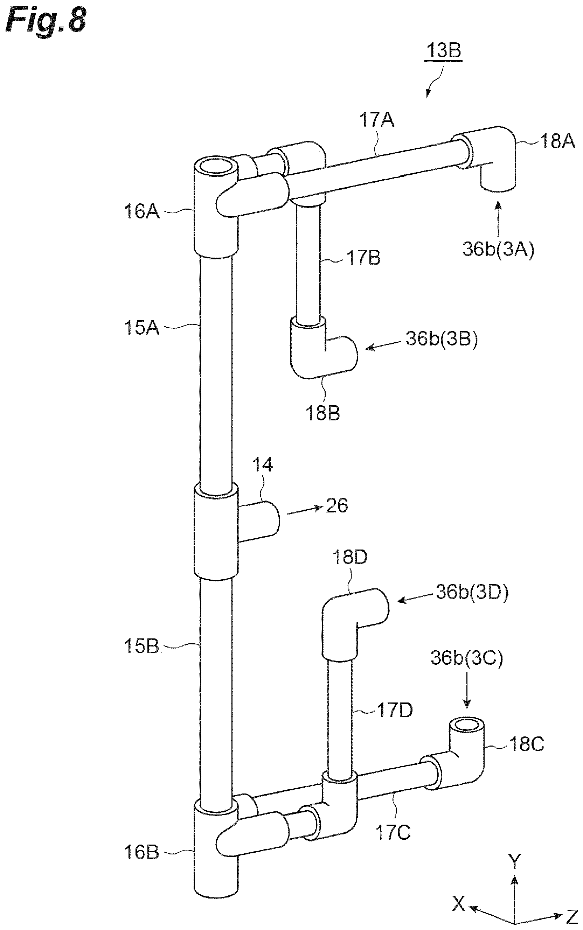

The laser light source unit 10 further includes a plurality of piping units 13A and 13B as illustrated in FIGS. 7 and 8. The piping units 13A and 13B each include a connection part 14, a pair of hoses 15A and 15B, a pair of joint parts 16A and 16B, a plurality of hoses 17A, 17B, 17C, and 17D, and a plurality of connection parts 18A, 18B, 18C, and 18D. The hoses 15A, 15B, 17A, 17B, 17C, and 17D each have flexibility. Further, illustration of the plurality of piping units 13A and 13B is omitted in FIGS. 3, 4, 5, and 6.

One end portion of the hose 15A is connected to the connection part 14, and the other end portion of the hose 15Ais connected to the joint part 16A. One end portion of the hose 15B is connected to the connection part 14, and the other end portion of the hose 15B is connected to the joint part 16B. One end portion of the hose 17A is connected to the joint part 16A, and the other end portion of the hose 17A is connected to the connection part 18A. One end portion of the hose 17B is connected to the joint part 16A, and the other end portion of the hose 17B is connected to the connection part 18B. One end portion of the hose 17C is connected to the joint part 16B, and the other end portion of the hose 17C is connected to the connection part 18C. One end portion of the hose 17D is connected to the joint part 16B, and the other end portion of the hose 17D is connected to the connection part 18D.

As illustrated in FIG. 7, the connection part 14 of each of the piping units 13Ais connected to each of the sub-outlet ports 25 (see FIG. 4). The connection part 18A of the piping unit 13A is connected to the introduction port 36a of the laser light source 3A (see FIG. 3). The connection part 18B of the piping unit 13A is connected to the introduction port 36a of the laser light source 3B (see FIG. 3). The connection part 18C of the piping unit 13A is connected to the introduction port 36a of the laser light source 3C. The connection part 18D of the piping unit 13A is connected to the introduction port 36a of the laser light source 3D. The hoses 17A, 17B, 17C, and 17D of the piping units 13A are respectively connected to the refrigerant flow paths 36 of the laser light sources 3A, 3B, 3C, and 3D.

As illustrated in FIG. 8, the connection part 14 of each of the piping units 13B is connected to each of the sub-introduction ports 26 (see FIG. 4). The connection part 18A of the piping unit 13B is connected to the outlet port 36b of the laser light source 3A (see FIG. 3). The connection part 18B of the piping unit 13B is connected to the outlet port 36b of the laser light source 3B (see FIG. 3). The connection part 18C of the piping unit 13B is connected to the outlet port 36b of the laser light source 3C. The connection part 18D of the piping unit 13B is connected to the outlet port 36b of the laser light source 3D. The hoses 17A, 17B, 17C, and 17D of the piping units 13B are respectively connected to the refrigerant flow paths 36 of the laser light sources 3A, 3B, 3C, and 3D.

In the laser device 1, the refrigerant is introduced from the main introduction pipe 11 into the refrigerant supply flow path of the rear portion 23 through the main introduction port 24, and the refrigerant is introduced into the refrigerant flow paths 36 of the laser light sources 3A, 3B, 3C, and 3D via the sub-outlet ports 25 and the piping units 13A. Then, the refrigerant is introduced from the refrigerant flow paths 36 of the laser light sources 3A, 3B, 3C, and 3D into the refrigerant recovery flow path of the rear portion 23 via the piping units 13B and the sub-introduction ports 26, and the refrigerant is discharged from the main outlet pipe 12 through the main outlet port 27.

### [Operation and effects]

In the laser device 1, the laser light sources 3A, 3B, 3C, and 3D are each movable with respect to the support 2, the extension part 81 between the first connection portion P1 and the second connection portion P2 has flexibility in each of the electrodes 8A, 8B, 8C, and 8D, and a length of the extension part 81 is longer than a linear distance between the first connection portion P1 and the second connection portion P2. Thereby, positions of the laser light sources 3A, 3B, 3C, and 3D can be adjusted in a state in which the electrodes 8A, 8B, 8C, and 8D are electrically connected to the laser light sources 3A, 3B, 3C, and 3D. Therefore, it is possible to adjust positions of the laser light sources 3A, 3B, 3C, and 3D while ascertaining irradiation patterns (that is, irradiation patterns of the laser light that can be applied to the solid-state laser medium S) of laser light emitted from the laser light sources 3A, 3B, 3C, and 3D. Further, since the electrodes 8A and 8B are thermally connected to the heat sink 7A, and the electrodes 8C and 8D are thermally connected to the heat sink 7B, deterioration of the electrodes 8A, 8B, 8C, and 8D due to heat generation can be suppressed. Therefore, according to the laser device 1, a high-quality optical output can be reliably obtained with a simple configuration.

In the laser device 1, the electrodes 8A, 8B, 8C, and 8D each have a sheet shape. Thereby, manufacturing can be facilitated compared to a case in which, for example, the electrodes 8A, 8B, 8C, and 8D are each configured by a plurality of wires. Also, deterioration of the electrodes 8A, 8B, 8C, and 8D due to heat generation can be suppressed while maintaining flexibility of the extension part 81 compared to a case in which, for example, the electrodes 8A, 8B, 8C, and 8D are each configured by a plurality of wires. This is because, in order to suppress deterioration of the electrode due to heat generation in the electrode configured by the plurality of wires, each of the wires needs to be made thicker or the number of wires needs to be increased, and in such a case, flexibility of the electrode is impaired. Further, when the electrodes 8A, 8B, 8C, and 8D each have a sheet shape, there is an advantage that physical disconnection does not easily occur even if the electrodes 8A, 8B, 8C, and 8D are bent or twisted compared to a case in which, for example, the electrodes are each configured by a plurality of wires.

In the laser device 1, the extension parts 81 of the electrodes 8A, 8B, 8C, and 8D are each floated in the air between the first connection portion P1 and the second connection portion P2. Thereby, positions of the laser light sources 3A, 3B, 3C, and 3D can be more easily adjusted with the electrodes 8A, 8B, 8C, and 8D electrically connected to the laser light sources 3A, 3B, 3C, and 3D.

In the laser device 1, each of the heat sinks 7A and 7B is provided with the refrigerant flow path 71. Thereby, the electrodes 8A, 8B, 8C, and 8D can be more efficiently cooled.

In the laser device 1, the laser light sources 3A, 3B, 3C, and 3D each include the heat sink 32 and the semiconductor laser array 33 that is thermally connected to the heat sink 32. Thereby, the semiconductor laser array 33 can be efficiently cooled in each of the laser light sources 3A, 3B, 3C, and 3D. Since an amount of heat due to the semiconductor laser array 33 is larger than an amount of heat due to a single-element semiconductor laser, a configuration in which the semiconductor laser array 33 is cooled using the heat sink 32 is effective.

In the laser device 1, the heat sink 32 is provided with the refrigerant flow path 36. Thereby, the semiconductor laser array 33 can be more efficiently cooled in each of the laser light sources 3A, 3B, 3C, and 3D.

In the laser device 1, the hoses 17A, 17B, 17C, and 17D having flexibility are connected to the refrigerant flow paths 36 of the laser light sources 3A, 3B, 3C, and 3D. Thereby, positions of the laser light sources 3A, 3B, 3C, and 3D can be more easily adjusted with the electrodes 8A, 8B, 8C, and 8D electrically connected to the laser light sources 3A, 3B, 3C, and 3D.

In the laser device 1, the plurality of semiconductor laser arrays 33 in the respective laser light sources 3A, 3B, 3C, and 3D are electrically connected in series by the conductive members 9A, 9B, 9C, and 9D. Thereby, wiring can be simplified, and furthermore, a size of the laser device 1 can be reduced.

In the laser device 1, the conductive members 9A and 9B are thermally connected to the heat sink 7A, and the conductive members 9C and 9D are thermally connected to the heat sink 7B. Thereby, deterioration of the conductive members 9A, 9B, 9C, and 9D due to heat generation can be suppressed.

In the laser device 1, cross-sectional areas of the conductive members 9A, 9B, 9C, and 9D are larger than cross-sectional areas of the electrodes 8A, 8B, 8C, and 8D, respectively. Thereby, electrical resistance of the plurality of electrodes 8A and the plurality of conductive members 9A as a whole can be lowered, and heat generation of them as a whole can be suppressed. The same applies to all of the plurality of electrodes 8B and the plurality of conductive members 9B, all of the plurality of electrodes 8C and the plurality of conductive members 9C, and all of the plurality of electrodes 8D and the plurality of conductive members 9D.

In the laser device 1, the mirror 5A reflects laser light emitted from the laser light source 3A, and transmits laser light emitted from the laser light source 3B. Thereby, the laser light emitted from the laser light source 3A and the laser light emitted from the laser light source 3B can be combined in a desired state by adjusting a positional relationship between the corresponding laser light sources 3A and 3B. Similarly, the mirror 5B reflects laser light emitted from the laser light source 3C, and transmits laser light emitted from the laser light source 3D. Thereby, the laser light emitted from the laser light source 3C and the laser light emitted from the laser light source 3D can be combined in a desired state by adjusting positions between the corresponding laser light sources 3C and 3D.

In the laser device 1, the laser light source 3A and 3B each include the plurality of semiconductor laser bars 33a stacked in the X-axis direction, and the laser light source 3A and 3B are each movable with respect to the support 2 in the X-axis direction. Thereby, gaps between laser light emitted from the semiconductor laser bars 33a of the laser light source 3A can be filled with laser light emitted from the semiconductor laser bars 33a of the laser light source 3B by adjusting a positional relationship between the corresponding laser light sources 3A and 3B. Similarly, the laser light source 3C and 3D each include the plurality of semiconductor laser bars 33a stacked in the X-axis direction, and the laser light source 3C and 3D are each movable with respect to the support 2 in the X-axis direction. Thereby, gaps between laser light emitted from the semiconductor laser bars 33a of the laser light source 3C can be filled with laser light emitted from the semiconductor laser bars 33a of the laser light source 3D by adjusting a positional relationship between the corresponding laser light sources 3C and 3D.

In the laser device 1, the mirror 5A includes the plurality of light reflecting portions 51 that reflect the laser light emitted from the laser light source 3A, and the plurality of light transmitting portions 52 that transmit the laser light emitted from the laser light source 3B, and the light reflecting portions 51 and the light transmitting portions 52 are alternately aligned in the X-axis direction in the mirror 5A. Thereby, the laser light emitted from the laser light source 3A can be reliably made incident on the light reflecting portions 51 by adjusting a position of the laser light source 3A. Also, the laser light emitted from the laser light source 3B can be reliably made incident on the light transmitting portions 52 by adjusting a position of the laser light source 3B. Similarly, the mirror 5B includes the plurality of light reflecting portions 51 that reflect the laser light emitted from the laser light source 3C, and the plurality of light transmitting portions 52 that transmit the laser light emitted from the laser light source 3D, and the light reflecting portions 51 and the light transmitting portions 52 are alternately aligned in the X-axis direction in the mirror 5B. Thereby, the laser light emitted from the laser light source 3C can be reliably made incident on the light reflecting portions 51 by adjusting a position of the laser light source 3C. Also, the laser light emitted from the laser light source 3D can be reliably made incident on the light transmitting portions 52 by adjusting a position of the laser light source 3D. As a result of the above, a high-quality optical output can be obtained while reducing loss of light.

In the laser device 1, the laser light emitted from the laser light sources 3A, 3B, 3C, and 3D are collected into the solid-state laser medium S by the prism optical system 100. Thereby, a high-quality optical output can be obtained in the solid-state laser medium S.

### [Modified example]

The present disclosure is not limited to the embodiments described above. For example, the electrodes 8A, 8B, 8C, and 8D need only have flexibility at least in the extension part 81. The electrodes 8A, 8B, 8C, and 8D are not limited to having a sheet shape, and may, for example, be configured by a plurality of wires or have a spring-shaped extension part 81. In each of the electrodes 8A, 8B, 8C, and 8D, the extension part 81 may not be floated in the air between the first connection portion P1 and the second connection portion P2.

Each of the heat sinks 7A and 7B may be provided with the refrigerant flow path 71. Each of the laser light sources 3A, 3B, 3C, and 3D may not include the heat sink 32 and the semiconductor laser array 33. For example, the laser light sources 3A, 3B, 3C, and 3D may each be constituted by a single-element semiconductor laser. In each of the laser light sources 3A, 3B, 3C, and 3D, the heat sink 32 may not be provided with the refrigerant flow path 36. The laser light source 3A, 3B, 3C, and 3D may each be movable with respect to the support 2 in directions other than the X-axis direction. The prism optical system 100 need only be any system that collects the laser light emitted from the laser light sources 3A, 3B, 3C, and 3D into a predetermined region.

The laser light source unit 10 may include other optical elements such as a polarization coupler and a wavelength coupler instead of the mirrors 5A and 5B. A polarization coupler need only reflect laser light of first polarized light (for example, one of P-polarized light and S-polarized light) and transmit laser light of second polarized light (for example, the other of P-polarized light and S-polarized light) that is different from the first polarized light. A wavelength coupler need only reflect laser light of a first wavelength and transmit laser light of a second wavelength that is different from the first wavelength. However, according to the mirrors 5A and 5B, it is possible to reliably and easily realize a configuration in which laser light incident in the Y-axis direction is reflected and laser light incident in the Z-axis direction is transmitted.

Various materials and shapes can be applied to each configuration in the embodiment described above without being limited to the above-described materials and shapes. Also, each configuration in one embodiment or modified example described above can be arbitrarily applied to each configuration in another embodiment or modified example.

### Reference Signs List

1 Laser device
2 Support
3A, 3B, 3C, 3D Laser light source
5A, 5B Mirror (optical element)
7A, 7B Heat sink (first heat sink)
8A, 8B, 8C, 8D Electrode
9A, 9B, 9C, 9D Conductive member
17A, 17B, 17C, 17D Hose
32 Heat sink (second heat sink)
33 Semiconductor laser array
33a Semiconductor laser bar
36 Refrigerant flow path (second refrigerant flow path)
51 Light reflecting portion
52 Light transmitting portion
71 Refrigerant flow path (first refrigerant flow path)
81 Extension part
100 Prism optical system
P1 First connection portion
P2 Second connection portion
S Solid-state laser medium (predetermined region)

## Claims

1. A laser device comprising:
a support;
a first heat sink;
a plurality of laser light sources attached to the support; and
a plurality of electrodes bridged between the plurality of laser light sources and the first heat sink, wherein
each of the plurality of laser light sources is movable with respect to the support,
each of the plurality of electrodes is electrically connected to each of the plurality of laser light sources at a first connection portion, and is thermally connected to the first heat sink at a second connection portion,
an extension part between the first connection portion and the second connection portion has flexibility in each of the plurality of electrodes, and
a length of the extension part is larger than a linear distance between the first connection portion and the second connection portion.

2. The laser device according to claim 1, wherein each of the plurality of electrodes has a sheet shape.

3. The laser device according to claim 1 or 2, wherein the extension part is floated in an air between the first connection portion and the second connection portion.

4. The laser device according to any one of claims 1 to 3, wherein the first heat sink is provided with a first refrigerant flow path.

5. The laser device according to any one of claims 1 to 4, wherein each of the plurality of laser light sources includes:
a second heat sink; and
a semiconductor laser array thermally connected to the second heat sink.

6. The laser device according to claim 5, wherein the second heat sink is provided with a second refrigerant flow path.

7. The laser device according to claim 6, further comprising a plurality of hoses having flexibility, wherein
each of the plurality of hoses is connected to the second refrigerant flow path.

8. The laser device according to any one of claims 1 to 7, further comprising a conductive member, wherein
the plurality of laser light sources include a first laser light source and a second laser light source,
the plurality of electrodes include a first electrode electrically connected to a cathode of the first laser light source and a second electrode electrically connected to an anode of the second laser light source, and
the first electrode and the second electrode are electrically connected by the conductive member.

9. The laser device according to claim 8, wherein the conductive member is thermally connected to the first heat sink.

10. The laser device according to claim 8 or 9, wherein a cross-sectional area of the conductive member is larger than a cross-sectional area of each of the first electrode and the second electrode.

11. The laser device according to any one of claims 1 to 10, further comprising an optical element, wherein
the plurality of laser light sources include a third laser light source configured to emit laser light toward the optical element in a first direction, and a fourth laser light source configured to emit laser light toward the optical element in a second direction intersecting the first direction, and
the optical element reflects the laser light emitted from the third laser light source and transmits the laser light emitted from the fourth laser light source.

12. The laser device according to claim 11, wherein the optical element is a mirror.

13. The laser device according to claim 11 or 12, wherein
each of the third laser light source and the fourth laser light source includes a plurality of semiconductor laser bars stacked in a third direction intersecting both the first direction and the second direction, and
each of the third laser light source and the fourth laser light source is movable in the third direction with respect to the support.

14. The laser device according to claim 13, wherein
the optical element includes:
a plurality of light reflecting portions configured to reflect the laser light emitted from the third laser light source; and
a plurality of light transmitting portions configured to transmit the laser light emitted from the fourth laser light source, and
the plurality of light reflecting portions and the plurality of light transmitting portions are alternately aligned in the third direction.

15. The laser device according to any one of claims 1 to 14, further comprising a prism optical system configured to collect laser light emitted from each of the plurality of laser light sources into a predetermined region.
